# EUROPEAN PATENT APPLICATION

(11) **EP 4 579 765 A1**
(43) Date of publication of application: **02.07.2025**
(21) Application number: 24798381.0
(22) Date of filing: 11.04.2024
(51) Int. Cl.: H01L 31/049

(54) **CURVED SURFACE PHOTOVOLTAIC MEMBER AND PHOTOVOLTAIC BUILDING SURFACE**

(30) Priority: 14.11.2023 CN 202311518157
(71) Applicant: Shenzhen Hello Tech Energy Co., Ltd, Shenzhen, Guangdong 518109 (CN)
(72) Inventor: YU, Huajun, Shenzhen, Guangdong 518109 (CN); SUN, Zhongwei, Shenzhen, Guangdong 518109 (CN); ZHU, Yanjun, Shenzhen, Guangdong 518109 (CN)
(74) Representative: Range, Christopher William
(86) International application number: PCT/CN2024/087298
(87) International publication number: WO 2025/102596

(57) **Abstract**

A curved photovoltaic member (100) includes a solar cell (50), a front plate (10), a conductive layer (60), and a back plate (90). The front plate (10) is located at a side of the solar cell (50) where a light receiving surface (51) is located. The conductive layer (60) is electrically connected to the solar cell (50) and is located at a side of the solar cell (50) where a back surface (53) is located. The back plate (90) is located at a side of the conductive layer (60) away from the solar cell (50).

## Description

### CROSS-REFERENCE TO RELATED APPLICATION

This application claims priority to Chinese patent application No. 202311518157.9, filed with China National Intellectual Property Administration on November 14, 2023, which is incorporated herein by reference.

### FIELD

The present disclosure relates to the technical field of photovoltaic technologies, and more particularly, to a curved photovoltaic member and a photovoltaic building surface.

### BACKGROUND

In order to be matched and mounted with traditional tiles on building, curved photovoltaic tiles have emerged. The original curved photovoltaic tile is developed based on a flexible copper-indium-gallium-selenide solar cell. Although the copper-indium-gallium-selenide solar cell has remarkable flexibility characteristics, the copper-indium-gallium-selenide solar cell only has power generation efficiency ranging from 12% to 14% and a high cost. In order to improve the power generation efficiency and reduce the cost, most of the current curved photovoltaic tiles use crystalline-silicon solar cells, and the used crystalline-silicon solar cell has a high photoelectric conversion efficiency. However, due to high brittleness of the crystalline-silicon solar cell, the crystalline-silicon solar cell is easy to fracture when subjected to a bending stress, resulting in a small ratio of arc length to a corresponding chord length of the curve segment of the current curved photovoltaic tile, thereby leading to a poor fit between the curved photovoltaic tile and the building.

### SUMMARY

An implementation of the present disclosure provides a curved photovoltaic member and a photovoltaic building surface, which are at least used to solve problems that the curved photovoltaic member has a small curve curvature and a poor fit between the curved photovoltaic tile and the building.

The curved photovoltaic member according to the implementations of the present disclosure includes a solar cell, a front plate, a conductive layer, and a back plate. The solar cell has a light receiving surface and a back surface opposite to the light receiving surface. The front plate is located at a side of the solar cell where the light receiving surface is located. The conductive layer is electrically connected to the solar cell and located at a side of the solar cell where the back surface is located. The back plate is located at a side of the conductive layer away from the solar cell. The front plate, the solar cell, the conductive layer, and the back plate are sequentially laminated.

In some implementations, each of the front plate, the solar cell, and the back plate is in a shape with a curved surface.

In some implementations, the solar cell has a bending radius ranging from 25 mm to 200 mm.

In some implementations, a longitudinal projection of the curved surface is a curve constituted by one curve segment; a longitudinal projection of the curved surface is a curve constituted by a plurality of curve segments connected in sequence; or a longitudinal projection of the curved surface is a special-shaped curve constituted by a plurality of curve segments and a straight segment. The curve segment is arc-shaped, a ratio of an arc length to a corresponding chord length of the curve segment ranging from 1.03 to1.67.

In some implementations, when the longitudinal projection of the curved surface is the curve constituted by the plurality of curve segments connected in sequence, two adjacent curve segments of the plurality of curve segments have opposite bending directions, and the plurality of curve segments have a same bending radius. When the longitudinal projection of the curved surface is the special-shaped curve constituted by the plurality of curve segments and the straight segment, the plurality of curve segments have a same bending direction and a same bending radius.

In some implementations, the solar cell includes a positive electrode and a negative electrode that are disposed on the back surface of the solar cell. The conductive layer is connected to the positive electrode of one of two adjacent solar cells and the negative electrode of another of the two adjacent solar cells.

In some implementations, the solar cell is one-piece solar cell or multiple pieces of solar cells.

In some implementations, a plurality of solar cells is arranged at intervals, and the curved photovoltaic member further includes a shielding member. The shielding member is disposed at light receiving surfaces of two adjacent solar cells of the plurality of solar cells, and an interval between the two adjacent solar cells is shielded by the shielding member.

In some implementations, two adjacent solar cells are seamlessly spliced.

In some implementations, the light receiving surface of one of the two adjacent solar cells is seamlessly overlapped with the back surface of another of the two adjacent solar cells.

In some implementations, the curved photovoltaic member further includes a first adhesive layer and a second adhesive layer. The first adhesive layer is configured to connect the front plate and the solar cell, and the second adhesive layer is configured to connect the solar cell, the conductive layer, and the back plate.

In some embodiments, the conductive layer is black.

A photovoltaic building surface according to the implementations of the present disclosure includes a plurality of curved photovoltaic members according to any one of the implementations as described above. Adjacent curved photovoltaic members are connected to each other.

In the curved photovoltaic member according to the implementations of the present disclosure, the conductive layer is provided only at the back surface, and the conductive layer is not provided at the light receiving surface. In this way, a contact area between the light receiving surface and light is larger, a light utilization rate of the solar cell is higher, and a power generation efficiency of the curved photovoltaic member is higher. Moreover, since the conductive layer is provided at one side of the solar cell, the solar cell may be entirely bent with a large curvature, and the curved photovoltaic member has a large bending curvature. Compared with the current curved photovoltaic member, the curved photovoltaic member according to the implementations of the present disclosure has a large curve curvature, and provides better fit with the building.

Additional aspects and advantages of the present disclosure will be given in part in the following description, or become apparent in part from the following description, or can be learned from practicing of the present disclosure.

### BRIEF DESCRIPTION OF THE DRAWINGS

The above and/or additional aspects and advantages of the present disclosure will become more apparent and more understandable from the following description of implementations taken in conjunction with the accompanying drawings, in which:
FIG. 1 is a schematic structural view showing a curved photovoltaic member according to an implementation of the present disclosure.
FIG. 2 is a schematic structural view showing a curved photovoltaic member according to another implementation of the present disclosure.
FIG. 3 is a schematic structural view showing a curved photovoltaic member according to yet another implementation of the present disclosure.
FIG. 4 is a schematic structural view showing a solar cell and a conductive layer in a curved photovoltaic member according to an implementation of the present disclosure.
FIG. 5 is a schematic structural view showing a solar cell and a conductive layer in a curved photovoltaic member according to another implementation of the present disclosure.
FIG. 6 is a schematic structural view showing a solar cell and a conductive layer in a curved photovoltaic member according to yet another implementation of the present disclosure.
FIG. 7 is a schematic structural view showing a photovoltaic building surface according to some implementations of the present disclosure.

### DETAILED DESCRIPTION

In order to clarify the above-mentioned objects, features, and advantages of the present disclosure, specific implementations of the present disclosure are described in detail below in conjunction with the accompanying drawings. In the following description, many specific details are provided to facilitate full understanding of the present disclosure. However, the present disclosure can be implemented in various manners other than those described herein, and similar improvements can be made by those skilled in the art without contradicting the intent of the present disclosure. Therefore, the present disclosure is not limited by specific implementations disclosed below.

In the description of the present disclosure, it needs to be understood that, orientation or position relationship indicated by terms such as "longitudinal", "lateral", "length", "width", "thickness", "over", "below", "front", "back", "left", "right", "vertical", "horizontal", "top", "bottom", "in", "out", "clockwise", "anti-clockwise", "axial", "radial" and "circumferential" is based on the orientation or position relationship shown in the accompanying drawings, and is merely for the convenience of describing the present disclosure and simplifying the description, rather than indicating or implying that the associated device or element must have a specific orientation, or be constructed and operated in a specific orientation, and therefore cannot be understood as a limitation on the present disclosure.

In addition, the terms "first" and "second" are only used for descriptive purposes, and cannot be understood as indicating or implying relative importance or implicitly indicating the number of indicated technical features. Therefore, the features associated with "first" and "second" may explicitly or implicitly include at least one of the features. In the description of the present disclosure, "plurality of" means at least two, such as two, three, etc., unless otherwise specifically defined.

In the present disclosure, unless otherwise clearly specified and limited, terms such as "install", "connect", "connect to", "fix" and the like should be understood in a broad sense. For example, it may be a fixed connection or a detachable connection or connection as one piece; mechanical connection or electrical connection; direct connection or indirect connection through an intermediate; internal communication of two components or the interaction relationship between two components. For those skilled in the art, the specific meaning of the above-mentioned terms in the present disclosure can be understood according to specific circumstances.

In the present disclosure, unless expressly stipulated and defined otherwise, the first feature "on" or "under" the second feature may mean that the first feature is in direct contact with the second feature, or the first and second features are in indirect contact through an intermediate. Moreover, the first feature "above" the second feature may mean that the first feature is directly above or obliquely above the second feature, or simply mean that the level of the first feature is higher than that of the second feature. The first feature "below" the second feature may mean that the first feature is directly below or obliquely below the second feature, or simply mean that the level of the first feature is smaller than that of the second feature.

It should be noted that when an element is referred to as being "fixed to" or "disposed at" another element, it can be directly at the other element or a centered element may also occur. When an element is considered to be "connected to" another element, it may be directly connected to the other element or a centered element may occur simultaneously. As used herein, the terms "vertical", "horizontal", "over", "below", "left", "right", and similar expressions are for illustrative purposes only and are not meant to be the only implementations.

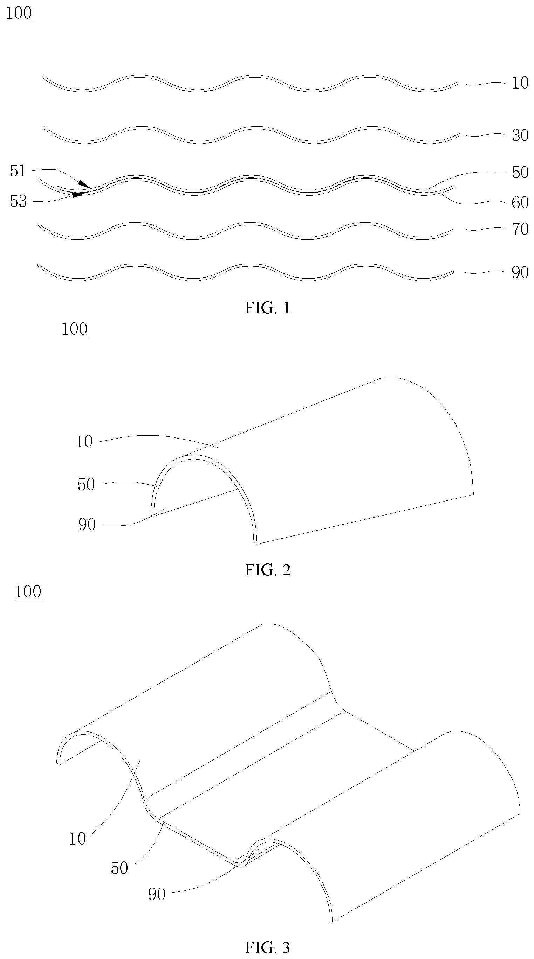

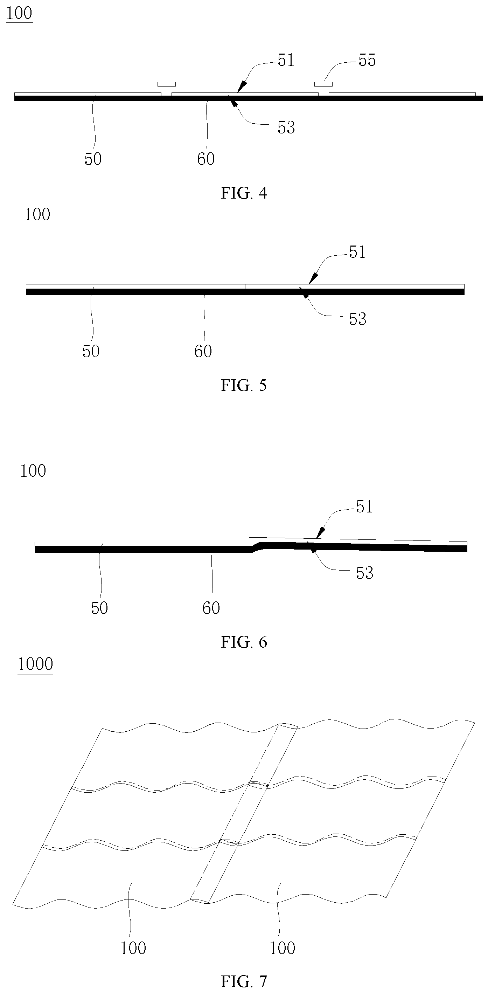

In order to be matched and mounted with traditional tiles on building, curved photovoltaic tiles have emerged. The original curved photovoltaic tile is developed based on a flexible copper-indium-gallium-selenide solar cell. Although the copper-indium-gallium-selenide solar cell has remarkable flexibility characteristics, the copper-indium-gallium-selenide solar cell only has power generation efficiency ranging from 12% to 14% and a high cost. In order to improve the power generation efficiency and reduce the cost, most of the current curved photovoltaic tiles use crystalline-silicon solar cells, and the used crystalline-silicon solar cell has a high photoelectric conversion efficiency. However, due to high brittleness of the crystalline-silicon solar cell, the crystalline-silicon solar cell is easy to fracture when subjected to a bending stress, resulting in a small ratio of arc length to a corresponding chord length of the curve segment of the current curved photovoltaic tile, thereby leading to a poor fit between the curved photovoltaic tile and the building. In order to solve this problem, the implementations of the present disclosure provide a curved photovoltaic member 100 (as shown in FIG. 1) and a photovoltaic building surface 1000 (as shown in FIG. 5).

Referring to FIG. 1 and FIG. 2, a curved photovoltaic member 100 according to the implementations of the present disclosure includes a solar cell 50, a front plate 10, a conductive layer 60, and a back plate 90. The solar cell 50 has a light receiving surface 51 and a back surface 53 opposite to the light receiving surface 51. The front plate 10 is located at a side of the solar cell 50 where the light receiving surface 51 is located. The conductive layer 60 is electrically connected to the solar cell 50 and located at a side of the solar cell 50 where the back surface 53 is located. The back plate 90 is located at a side of the conductive layer 60 away from the solar cell 50. The front plate 10, the solar cell 50, the conductive layer 60, and the back plate 90 are sequentially laminated.

Specifically, the curved photovoltaic member 100 is a structure that is configured to convert light energy into electric energy to supply power for other elements, and may be used as a component of the building. The curved photovoltaic member 100 may be mounted at a top or a side surface of the building. The curved photovoltaic member 100 may also make aesthetics of the building good while may generate electricity.

The front plate 10 is a structure for protecting the light receiving surface 51 of the solar cell 50. Preferably, light transmittance of the front plate 10 is high. For example, the light transmittance may be greater than or equal to 70%, so that most or even all of the light may pass through the front plate 10 to reach the solar cell 50, enabling the solar cell 50 to convert the received light energy into electric energy. For example, the light transmittance of the front plate 10 may be 70%, 73.1%, 75.6%, 77%, 78.5%, 80.3%, 83%, 85.1%, 87.2%, 90.5%, 92.4%, 93.7%, 95.6%, 97.8%, or 100%. A material of the front plate 10 may be, but is not limited to, transparent glass, polycarbonate plastic, and the like. When the front plate 10 is made of transparent glass, light transmittance of the front plate 10 made of transparent glass may reach 85% to 90%. The light transmittance of the front plate 10 is high, and a strength of the front plate 10 made of transparent glass is high, so that the solar cell 50 may be better protected. When the front plate 10 is made of polycarbonate plastic, light transmittance of the polycarbonate front plate 10 may reach 89%, and the light transmittance of the front plate 10 is also high. The polycarbonate front plate 10 has good bending performance and a light weight, so that the curved photovoltaic member 100 is light in weight as a whole and convenient to be carried and moved.

The back plate 90 is a structure for protecting the back surface 53 of the solar cell 50. The solar cell 50 is disposed between the front plate 10 and the back plate 90, and is protected by the front plate 10 and the back plate 90. A material of the back plate 90 may be the same as or different from the material of the front plate 10. The material of the back plate 90 may be, but is not limited to, glass or a polymer material. The polymer material includes a composite material of polyethylene terephthalate (PET) and PET. When the back plate 90 is made of glass, a strength of the back plate 90 is high, and may play a good protection role for the solar cell 50. When the back plate 90 is made of the polymer material, the back plate 90 has a light weight and good bending performance.

The solar cell 50 is a structure for converting the light energy into the electric energy. The light receiving surface 51 of the solar cell 50 is configured to receive the light energy and convert the light energy into the electric energy. The conductive layer 60 is welded to back surfaces 53 of a plurality of solar cells 50, and is used for connecting a positive electrode of one of adjacent solar cells 50 and a negative electrode of another of the adjacent solar cells 50. Moreover, the conductive layer 60 is also used for transmitting electrical energy generated in the plurality of solar cells 50 into a circuit, to enable the curved photovoltaic member 100 to supply power to other elements. Preferably, the conductive layer 60 is made of a metal material that includes, but is not limited to, silver, copper, and the like. The conductive layer 60 may be of a linear structure or sheet-like structure. The conductive layer 60 according to the implementations of the present disclosure is black. The black conductive layer 60 is connected to the back surface 53 of the solar cell 50, enabling the curved photovoltaic member 100 to be presented in uniformly black as a whole, with good aesthetics.

The solar cell 50 may be a thin-film solar cell or a crystalline-silicon solar cell. The solar cell 50 of the present disclosure is the crystalline-silicon solar cell. The solar cell 50 includes a positive electrode and a negative electrode that are disposed at the back surface 53 of the solar cell 50, so that the conductive layer 60 only needs to be connected to the back surface 53 of the solar cell 50. When the conductive layer 60 is provided at the solar cell 50 as the back surface 53, the light receiving surface 51 of the solar cell 50 has no shielding of the conductive layer 60, and photoelectric conversion efficiency of the solar cell 50 may be enhanced. Moreover, an appearance of the solar cell 50 is beautiful.

The positive and negative electrodes of the solar cell used in the current curved photovoltaic member are provided at the light receiving surface and the back surface of the solar cell, respectively. The conductive layer of the curved photovoltaic member needs to cross the light receiving surface and the back surface of the solar cell. When the solar cell is bent, the conductive layer tends to pull the solar cell, resulting in a small bending curvature of the solar cell and even fracture of the solar cell. Referring to FIG. 1 to FIG. 3, in the curved photovoltaic member 100 according to the implementations of the present disclosure, the conductive layer 60 is provided only at the back surface 53 of the solar cell 50. When the solar cell 50 is bent, the conductive layer 60 does not pull the solar cell 50, so that a curvature at which the solar cell 50 is bendable is large. Moreover, a risk of the fracture of solar cell 50 may be reduced.

In the curved photovoltaic member 100 according to the implementations of the present disclosure, the conductive layer 60 is provided only at the back surface 53 of the solar cell 50, and the conductive layer 60 is not provided at the light receiving surface 51. In this way, a contact area between the light receiving surface 51 and light is larger, a light utilization rate of the solar cell 50 is higher, and a power generation efficiency of the curved photovoltaic member 100 is higher. Moreover, since the conductive layer 60 is provided at a one side of the solar cell 50, the solar cell 50 is entirely bendable with a large curvature, and the curved photovoltaic member 100 has a large bending curvature. Compared with the current curved photovoltaic member, the curved photovoltaic member 100 according to the implementations of the present disclosure has a large curve curvature, and provides better fit with the building. Moreover, the curved photovoltaic member 100 has good aesthetics as a whole.

The curved photovoltaic member 100 is further described below with reference to the accompanying drawings.

Referring to FIG. 1, in some implementations, each of the front plate 10, the solar cell 50, and the back plate 90 is in a shape with a curved surface. Specifically, bending curvatures of the front plate 10, the solar cell 50, the conductive layer 60, and the back plate 90 are same, and the front plate 10, the solar cell 50, the conductive layer 60, and the back plate 90 have a same bending radius. The front plate 10 and the light receiving surface 51 of the solar cell 50, the conductive layer 60 and the back surface 53 of the solar cell 50, and the conductive layer 60 and the back plate 90 may be completely attached to each other.

Referring to FIG. 1, as described above, each of the front plate 10, the solar cell 50, and the back plate 90 is in the shape with a curved surface. In some implementations, a longitudinal projection of the curved surface is a curve constituted by one curve segment. As shown in FIG. 2. at this time, the curved photovoltaic member 100 has a small volume and a light weight, and is convenient to carry. In other some implementations, the longitudinal projection of the curved surface is a curve constituted by a plurality of curve segments connected in sequence. As shown in FIG. 1, at this time, the curve constituted by the plurality of curve segments is in a wavy shape. Moreover, a volume of the curved photovoltaic member 100 is large. Assembly and construction of the curved photovoltaic member 100 on the building are convenient. In other some implementations, the longitudinal projection of the curved surface is a special-shaped curve constituted by a plurality of curve segments and a straight segment. As shown in FIG. 3, at this time, the bending radius of the solar cell 50 is a bending radius at the largest curve in the shape with a curved surface, and the special-shaped curve is constituted by sequentially connecting the curve segments and the straight segment. The curved photovoltaic member 100 is beautiful as a whole. Moreover, mounting between the plurality of curved photovoltaic members 100 is stable.

Regardless of which one of the above implementations the curve is, each of the curve segments is arc-shaped. A ratio of an arc length to a corresponding chord length of the curve segment ranges from 1.03 to1.67. For example, the ratio of the arc length to the corresponding chord length of the curve segment h may be 1.03, 1.07, 1.11, 1.15, 1.19, 1.23, 1.25, 1.28, 1.31, 1.36, 1.41, 1.45, 1.47, 1.54, 1.58, or 1.67. A curve of a longitudinal projection of the front plate 10 is in a shape same as a curve of a longitudinal projection of the solar cell 50, a curve of a longitudinal projection of the conductive layer 60, and a curve of a longitudinal projection of the back plate 90. A ratio of an arc length to a corresponding chord length of the curve segment of the front plate 10 is the same as a ratio of an arc length to a corresponding chord length of the curve segment of the solar cell 50, a ratio of an arc length to a corresponding chord length of the curve segment of the conductive layer 60, and a ratio of an arc length to a corresponding chord length of the curve segment of the back plate 90.

When the ratio of the arc length to the corresponding chord length of the curve segment is smaller than 1.03, the curved photovoltaic member 100 has a less obvious bending curvature, and provides poor fit with the building, and not good enough aesthetics. When the ratio of the arc length to the corresponding chord length of the curve segment is greater than 1.67, the bending curvature of the curved photovoltaic member 100 is too large, which easily causes the fracture of the curved photovoltaic member 100. When the ratio of the arc length to the corresponding chord length of the curve segment ranges from 1.03 to1.67, the curved photovoltaic member 100 has an obvious bending curvature, and provides better fit with the building, and has a good aesthetics. Meanwhile, the curved photovoltaic member 100 is not easy to fracture.

Referring to FIG. 1, in some implementations, the solar cell 50 has a bending radius ranging from 25 mm to 200 mm. The bending radius of the solar cell 50 refers to a bending radius of each curve segment. At this time, the bending radius of the solar cell 50 may be 25 mm, 38.6 mm, 43.7 mm, 50 mm, 63.4 mm, 70.8 mm, 81.3 mm, 98.7 mm, 101 mm, 109.2 mm, 112.5 mm, 120.9 mm, 136.7 mm, 162.1 mm, 200 mm, or the like.

Specifically, when the bending radius of the solar cell 50 is smaller than 25 mm, the risk of the fracture of solar cell 50 easily occurs. When the bending radius of the solar cell 50 is greater than 200mm, the solar cell 50 has a less obvious bending curvature and a less enough aesthetics, and provides poor fit with the building. When the solar cell 50 has the bending radius ranging from 25 mm to 200 mm, the solar cell 50 has an obvious bending curvature and good aesthetics, and provides better fit with the building. Meanwhile, the solar cell 50 is not easy to fracture.

Continuing to refer to FIG. 1, in some implementations, when the longitudinal projection of the curved surface is the curve constituted by the plurality of curve segments connected in sequence, two adjacent curve segments of the plurality of curve segments have opposite bending directions, and the plurality of curve segments have a same bending radius. For example, when a first curve segment of the curved photovoltaic member 100 is in a similarly parabolic shape with an upward opening (a middle part of the curve segment is concave downwards), a second curve segment adjacent to the first curve segment is in a similarly parabolic shape with a downward opening (a middle part of the curve segment is convex upwards), a third curve segment adjacent to the second curve segment is in a similarly parabolic shape with a downward opening (a middle part of the curve segment is concave downwards), a fourth curve segment adjacent to the third curve segment is in a similarly parabolic shape with a downward opening (a middle part of the curve segment is convex upwards), and the rest can be done in the same manner. Therefore, the curve constituted by the plurality of curve segments is in a wavy shape. Moreover, the curve segments have a same bending radius. For example, a bending radius of the first curve segment is 70.8 mm, and a bending radius of each of the second curve segment, the third curve segment, and the rest of curve segments is also 70.8 mm. Alternatively, the bending radius of the first curve segment is 120 mm, and the bending radius of each of the second curve segment, the third curve segment, and the rest of curve segments is also 120 mm.

Referring to FIG. 3, in other some implementations, when the longitudinal projection of the curved surface is the special-shaped curve constituted by the plurality of curve segments and the straight segment, the plurality of curve segments have a same bending direction and a same bending radius. For example, each of the plurality of curve segments is in a similarly parabolic shape with a downward opening (a middle part of the curve segment is convex upwards), and two adjacent curve segments are connected to each other by the straight segment. The bending radii of the plurality of curve segments may be, but are not limited to, 63.4 mm, 70.8 mm, 76.8 mm, 81.3 mm, 83.5 mm, or 91.6 mm, etc.

Referring to FIG. 1, in some implementations, a thickness of the solar cell 50 ranges from 20 µm to 190 µm. For example, the thickness of the solar cell 50 may be 20 µm, 41.6 µm, 50.7 µm, 65.1 µm, 73 µm, 96.2 µm, 105.3 µm, 115 µm, 126.4 µm, 142.8 µm, 151.3 µm, 165.4 µm, 174 µm, 187.1 µm, or 190 µm. The thinner the solar cell 50, the better the bending performance of the solar cell 50. At present, the thinnest solar cell 50 that may be achieved in the industry has a thickness of 20 µm. When the thickness of the solar cell 50 is greater than 190 µm, the solar cell 50 is thick and has not good enough bending performance. Therefore, when the thickness of the solar cell 50 ranges from 20 µm to 190 µm, the thickness of the solar cell 50 is thin, and the bending performance of the solar cell 50 is good.

Referring to FIG. 1, in some implementations, the solar cell 50 is one-piece solar cell 50 or multiple pieces of solar cells 50.

Specifically, in an implementation, the solar cell 50 is the one-piece solar cell 50. At this time, processing of the solar cell 50 is simple. In another implementation, the solar cell 50 is the multiple pieces of solar cells 50. Specifically, one solar cell 50 is composed of the multiple pieces of solar cells. At this time, the solar cell 50 may achieve a large bending curvature. For example, the solar cell 50 may be two pieces of solar cells 50 (a 1/2-slice solar cell composed of two pieces of solar cells). The solar cell 50 may be three pieces of solar cells 50 (a 1/3-slice solar cell composed of three pieces of solar cells). The solar cell 50 may also be four pieces of solar cells 50 (a 1/4-slice composed of four pieces of solar cells), five pieces of solar cells 50 (a 1/5-slice composed of five pieces of solar cells), or six pieces of solar cells 50 (a 1/6 slice composed of six pieces of solar cells). In a case where one curve segment corresponds to one solar cell 50, in response to the solar cell 50 being processed into a 1/2-slice solar cell 50, two-sliced solar cells 50 may achieve a larger bending curvature than the entire solar cell 50. Moreover, the more pieces of solar cells 50, the larger the bending curvature that is reachable by the solar cell 50. In an example, each of the plurality of solar cells 50 is a solar cell 50 having a same quantity of slices. For example, each of the plurality of solar cells 50 is a 1/2-slice solar cell 50, a 1/3-slice solar cell 50, or a 1/4-slice solar cell 50. In another example, the plurality of solar cells 50 may be solar cells 50 having a different quantity of slices. For example, a part of the solar cells 50 are 1/2-slice solar cells50, and another part of the solar cells 50 are 1/4-slice solar cells 50. Alternatively, a part of the solar cells 50 are 1/3-slice solar cells50, and another part of the solar cells 50 are 1/6-slice solar cells 50.

Referring to FIG. 4 to FIG. 6, an arrangement of the plurality of solar cells 50 may be that the plurality of solar cells 50 are arranged sequentially, and an interval occurs between adjacent solar cells 50. Alternatively, the plurality of solar cells 50 are arranged sequentially, and no interval occurs between adjacent solar cells 50. In some implementations, an interval occurs between adjacent solar cells 50 (as shown in FIG. 4). When an interval occurs between the adjacent solar cells 50 at the light receiving surface 51, the solar cell 50 may have a large bending curvature and a small bending radius. When the bending radius of the solar cell 50 is small, because of the occurrence of the interval between the adjacent solar cells 50, there is no problem of the fracture of the solar cell 50 caused by an interference occurring between the adjacent solar cells 50.

Since the conductive layer 60 is welded to the back surfaces 53 of the plurality of solar cells 50, when an interval occurs between the adjacent solar cells 50, a welding band is exposed from the interval, resulting in uneven color of the solar cell 50 as a whole and poor aesthetics. In an example, the curved photovoltaic member 100 may further include a shielding member 55. The shielding member 55 is disposed at light receiving surface 51 of two adjacent solar cells 50 of the plurality of solar cells 50, and is used for shielding a welding band for welding the conductive layer 60 to the back surface 53 at the interval, so that all the solar cells 50 are presented in uniformly black as a whole, and the whole is beautiful. Preferably, a side of the shielding member 55 away from the light receiving surface 51 of the solar cell 50 is black, and the shielding member 55 may be made of a soft material, enabling the shielding member 55 also to be deformed accordingly during bending of the solar cell 50. Therefore, the problem of the fracture of the solar cell 50 caused by generation of interference with the solar cell 50 can be avoided. For example, the shielding member 55 may be a black adhesive tape. When the interval between the adjacent solar cells 50 is 5 mm, a width of the shielding member 55 needs to be greater than 5 mm. For example, the width of the shielding member 55 may be 10 mm. When the width of the shielding member 55 is greater than a width of the interval, the shielding member 55 may be firmly connected to the two solar cells 50 while shielding the welding band, thereby avoiding a problem that the shielding member 55 falls off due to unstable adhesion between the shielding member 55 and the solar cell 50. Of course, in other examples, the curved photovoltaic member 100 may not include the shielding member 55. In another example, the welding band exposed between the adjacent solar cells 50 is shielded by black screen printing, so that all the solar cells 50 are presented in uniformly black as a whole, and the whole is beautiful. In yet another example, the curved photovoltaic member 100 may also use a black welding band. When an interval occurs between the adjacent solar cells 50, the black welding band is exposed from the interval, so that all the solar cells 50 are presented in uniformly black as a whole, and the whole is beautiful.

In other some implementations, no gap occurs between the adjacent solar cells 50 (as shown in FIG. 5 and FIG. 6). In a case where no gap occurs between the adjacent solar cells 50, it is not necessary to provide the shielding member 55 shown in FIG. 2 between the solar cells 50. In this way, materials can be saved, and a processing technology of a product is simple. Moreover, since a part of an area of the light receiving surface 51 of the solar cell 50 is not shielded by the shielding member 55 shown in FIG. 2, an area of the light receiving surface 51 of the solar cell 50 in contact with the light is large, and the solar cell 50 has a high photoelectric conversion rate and a small loss of power generation amount. In an example, two adjacent solar cells 50 are seamlessly spliced (as shown in FIG. 5). In another example, a light receiving surface 51 of one of the two adjacent solar cells 50 is seamlessly overlapped with a back surface 53 of another of the two adjacent solar cells 50 (as shown in FIG. 6). Preferably, an overlapping width of the light receiving surface 51 of the one solar cell 50 with the back surface 53 of the other solar cell 50 may be greater than 0 mm and smaller than or equal to 1 mm. For example, the overlapping width of the light receiving surface 51 of the one solar cell 50 with the back surface 53 of the other solar cell 50 may be 0.11 mm, 0.23 mm, 0.35 mm, 0.4 mm, 0.51 mm, 0.67 mm, 0.74 mm, 0.8 mm, 0.91 mm, or 1 mm. When the overlapping width of the light receiving surface 51 of the one solar cell 50 with the back surface 53 of the other solar cell 50 is greater than 1 mm, a width at which the light receiving surface 51 of the one solar cell 50 is shielded by the other solar cell 50 is large. In this way, the loss of power generation amount of the solar cell 50 is large. When the overlapping width of the light receiving surface 51 of the one solar cell 50 with the back surface 53 of the other solar cell 50 is greater than 0 mm and smaller than or equal to 1 mm, no seam occurs between the two solar cells 50. Moreover, the width at which the light receiving surface 51 of the one solar cell 50 is shielded by the other solar cell 50 is small. In this way, the loss of power generation amount of the solar cell 50 is small.

Referring to FIG. 1, further, in some implementations, the curved photovoltaic member 100 further includes a first adhesive layer 30 and a second adhesive layer 70. The first adhesive layer 30 is configured to connect the front plate 10 and the solar cell 50, and the second adhesive layer 70 is configured to connect the solar cell 50, the conductive layer 60, and the back plate 90. The first adhesive layer 30 is light-transmitting.

Specifically, the first adhesive layer 30 is configured to tightly connect the front plate 10 and the light receiving surface 51 of the solar cell 50, and the second adhesive layer 70 is configured to tightly connect the back surface 53 to which the conductive layer 60 is welded and the back plate 90. Preferably, the first adhesive layer 30 may be an optically transparent adhesive. In this way, in a process where the light passes through the front plate 10 and the first adhesive layer 30 to reach the solar cell 50, an amount of loss of the light passing through the first adhesive layer 30 is small. For example, light transmittance of the first adhesive layer 30 may be greater than or equal to 70%. The light transmittance of the first adhesive layer 30 may be 70%, 72.5%, 76.8%, 79.4%, 81%, 83.6%, 85.4%, 87.1%, 91.2%, 94.7%, 95.8%, 97.4%, 100%, or the like. The optically transparent adhesive includes, but is not limited to, ethylene vinyl acetate (EVA), poly olefin elastomer (POE), polyvinyl butyral (PVB), silica gel, and the like.

In an implementation, the second adhesive layer 70 is lighttight and the back plate 90 is light-transmittable. The second adhesive layer 70 may be a black adhesive film or a transparent cutoff adhesive film. The black adhesive film is hardly light-transmitting. The transparent cutoff adhesive film has light transmittance smaller than or equal to 30%. The back plate 90 may be made of light-transmitting glass or a light-transmitting PET material. Preferably, the second adhesive layer 70 is the black adhesive film, enabling the curved photovoltaic member 100 to be presented in uniformly black as a whole, with good aesthetics. In another implementation, the back plate 90 is lighttight, and the second adhesive layer 70 is light-transmittable. At this time, the back plate 90 may be made of a black material. The black back plate 90 is hardly light-transmitting, and the second adhesive layer 70 may be a light-transmitting adhesive film, enabling the curved photovoltaic member 100 to be presented in uniformly black as a whole, with better aesthetics. In yet another implementation, each of the second adhesive layer 70 and the back plate 90 is lighttight. At this time, the second adhesive layer 70 may be the black adhesive film or the transparent cutoff adhesive film. The back plate 90 may be made of the black material, enabling the curved photovoltaic member 100 to be presented in uniformly black as a whole, with better aesthetics. In an example, the second adhesive layer 70 is the black adhesive film, and the back plate 90 is made of the black material. In another example, the second adhesive layer 70 is the transparent cutoff adhesive film, and the back plate 90 is made of the black material. In still yet another implementation, each of the second adhesive layer 70 and the back plate 90 may be light-transmittable. At this time, the second adhesive layer 70 may be the transparent adhesive film, and the back plate 90 may be made of a transparent material.

Referring to FIG. 7, a photovoltaic building surface 1000 according to the implementations of the present disclosure includes a plurality of curved photovoltaic members 100 according to any one of the above implementations. Adj acent curved photovoltaic members 100 are connected to each other. When the product is required to be waterproof, compared with a planar photovoltaic member, an area required to be overlapped when the adjacent curved photovoltaic members 100 are overlapped with each other is small, a contact area between the curved photovoltaic members 100 and the light is large, and the photoelectric conversion efficiency is high.

In the curved photovoltaic member 100 according to the implementations of the present disclosure, the conductive layer 60 is provided only at the back surface 53 of the solar cell 50, and the conductive layer 60 is not provided at the light receiving surface 51. In this way, a contact area between the light receiving surface 51 and light is larger, a light utilization rate of the solar cell 50 is higher, and a power generation efficiency of the curved photovoltaic member 100 is higher. Moreover, since the conductive layer 60 is provided at the one side of the solar cell 50, the solar cell 50 is entirely bendable with a large curvature, and the curved photovoltaic member 100 has a large bending curvature. Compared with the current curved photovoltaic member, the curved photovoltaic member 100 according to the implementations of the present disclosure has a large curve curvature, and provides better fit with the building. Moreover, the curved photovoltaic member 100 has good aesthetics as a whole.

The technical features of the above embodiments can be combined arbitrarily. In order to make the description simple, not every possible combination of the technical features in the above embodiments are described. However, as long as there is no conflict between the combinations of the technical features, any combination of the technical features should be considered as falling in the scope of this specification. Meanwhile, other implementations can be derived from the above-described embodiments, so that structural and logical substitutions and changes can be made without departing from the scope of the present disclosure.

The above embodiments illustrate merely some implementations of the present disclosure. Although description of the above embodiments is specific and detailed, the description should not be construed as limitations on the scope of the present disclosure. It should be pointed out that, various modifications and improvements can be made by those skilled in the art without departing from the concept of the embodiments of the present disclosure, and shall fall within the protection scope of the embodiments of the present disclosure as defined by the claims as attached.

## Claims

1. A curved photovoltaic member, comprising:
a solar cell having a light receiving surface and a back surface opposite to the light receiving surface;
a front plate located at a side of the solar cell where the light receiving surface is located;
a conductive layer electrically connected to the solar cell and located at a side of the solar cell where the back surface is located; and
a back plate located at a side of the conductive layer away from the solar cell, wherein the front plate, the solar cell, the conductive layer, and the back plate are sequentially laminated.

2. The curved photovoltaic member according to claim 1, wherein each of the front plate, the solar cell, and the back plate is in a shape with a curved surface.

3. The curved photovoltaic member according to claim 2, wherein the solar cell has a bending radius ranging from 25 mm to 200 mm.

4. The curved photovoltaic member according to claim 2, wherein:
a longitudinal projection of the curved surface is a curve constituted by one curve segment;
a longitudinal projection of the curved surface is a curve constituted by a plurality of curve segments connected in sequence; or
a longitudinal projection of the curved surface is a special-shaped curve constituted by a plurality of curve segments and a straight segment,
wherein the curve segment is arc-shaped, a ratio of an arc length to a corresponding chord length of the curve segment ranging from 1.03 to1.67.

5. The curved photovoltaic member according to claim 4, wherein:
when the longitudinal projection of the curved surface is the curve constituted by the plurality of curve segments connected in sequence, two adjacent curve segments of the plurality of curve segments have opposite bending directions, and the plurality of curve segments have a same bending radius; and
when the longitudinal projection of the curved surface is the special-shaped curve constituted by the plurality of curve segments and the straight segment, the plurality of curve segments have a same bending direction and a same bending radius.

6. The curved photovoltaic member according to claim 1, wherein the solar cell comprises a positive electrode and a negative electrode at the back surface of the solar cell, the conductive layer being connected to the positive electrode of one of two adjacent solar cells and the negative electrode of another of the two adjacent solar cells.

7. The curved photovoltaic member according to claim 1, wherein the solar cell is one-piece solar cell or multiple pieces of solar cells.

8. The curved photovoltaic member according to claim 1, wherein:
a plurality of solar cells is arranged at intervals; and
the curved photovoltaic member further comprises a shielding member,
wherein the shielding member is disposed at light receiving surfaces of two adjacent solar cells of the plurality of solar cells, and an interval between the two adjacent solar cells is shielded by the shielding member.

9. The curved photovoltaic member according to claim 1, wherein:
two adjacent solar cells are seamlessly spliced; or
the light receiving surface of one of the two adjacent solar cells is seamlessly overlapped with the back surface of another of the two adjacent solar cells.

10. The curved photovoltaic member according to claim 1, further comprising a first adhesive layer and a second adhesive layer, the first adhesive layer being configured to connect the front plate and the solar cell, and the second adhesive layer being configured to connect the solar cell, the conductive layer, and the back plate.

11. The curved photovoltaic member according to claim 1, wherein the conductive layer is black.

12. A photovoltaic building surface, comprising a plurality of curved photovoltaic members, adjacent curved photovoltaic members being connected to each other, each of the plurality of curved photovoltaic members comprising:
a solar cell having a light receiving surface and a back surface opposite to the light receiving surface;
a front plate located at a side of the solar cell where the light receiving surface is located;
a conductive layer electrically connected to the solar cell and located at a side of the solar cell where the back surface is located; and
a back plate located at a side of the conductive layer away from the solar cell, wherein the front plate, the solar cell, the conductive layer, and the back plate are sequentially laminated.

13. The photovoltaic building surface according to claim 12, wherein each of the front plate, the solar cell, and the back plate is in a shape with a curved surface.

14. The photovoltaic building surface according to claim 13, wherein the solar cell has a bending radius ranging from 25 mm to 200 mm.

15. The photovoltaic building surface according to claim 13, wherein:
a longitudinal projection of the curved surface is a curve constituted by one curve segment;
a longitudinal projection of the curved surface is a curve constituted by a plurality of curve segments connected in sequence; or
a longitudinal projection of the curved surface is a special-shaped curve constituted by a plurality of curve segments and a straight segment,
wherein the curve segment is arc-shaped, a ratio of an arc length to a corresponding chord length of the curve segment ranging from 1.03 to1.67.

16. The photovoltaic building surface according to claim 15, wherein:
when the longitudinal projection of the curved surface is the curve constituted by the plurality of curve segments connected in sequence, two adjacent curve segments of the plurality of curve segments have opposite bending directions, and the plurality of curve segments have a same bending radius; and
when the longitudinal projection of the curved surface is the special-shaped curve constituted by the plurality of curve segments and the straight segment, the plurality of curve segments have a same bending direction and a same bending radius.

17. The photovoltaic building surface according to claim 12, wherein the solar cell comprises a positive electrode and a negative electrode that are disposed on the back surface, the conductive layer being connected to the positive electrode of one of two adjacent solar cells and the negative electrode of another of the two adjacent solar cells.

18. The photovoltaic building surface according to claim 12, wherein the solar cell is one-piece solar cell or multiple pieces of solar cells.

19. The photovoltaic building surface according to claim 12, wherein:
a plurality of solar cells is arranged at intervals; and
the curved photovoltaic member further comprises a shielding member,
wherein the shielding member is disposed at light receiving surfaces of two adjacent solar cells of the plurality of solar cells, and an interval between the two adjacent solar cells is shielded by the shielding member.

20. The photovoltaic building surface according to claim 12, wherein
two adjacent solar cells are seamlessly spliced; or
the light receiving surface of one of the two adjacent solar cells is seamlessly overlapped with the back surface of another of the two adjacent solar cells.

21. The photovoltaic building surface according to claim 12, further comprising a first adhesive layer and a second adhesive layer, the first adhesive layer being configured to connect the front plate and the solar cell, and the second adhesive layer being configured to connect the solar cell, the conductive layer, and the back plate.

22. The photovoltaic building surface according to claim 12, wherein the conductive layer is black.
